(19)

Europäisches
Patentamt
European
Patent Office
Office européen
des brevets

(11) **EP 2 327 108 B1**

(12) **EUROPEAN PATENT SPECIFICATION**

(45) Date of publication and mention
of the grant of the patent:
**12.11.2014 Bulletin 2014/46**

(51) Int Cl.:
***H01L 31/055*** *(2014.01)*     ***H01L 31/054*** *(2014.01)*
***H01L 31/18*** *(2006.01)*

(21) Application number: **09787533.0**

(86) International application number:
**PCT/IL2009/000797**

(22) Date of filing: **13.08.2009**

(87) International publication number:
**WO 2010/023657 (04.03.2010 Gazette 2010/09)**

(54) **LUMINESCENT SOLAR CONCENTRATION**

LUMINESZENZ-SOLARKONZENTRATION

CONCENTRATION SOLAIRE LUMINESCENTE

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **26.08.2008 IL 19370108**

(43) Date of publication of application:
**01.06.2011 Bulletin 2011/22**

(73) Proprietor: **Greensun Energy Ltd.
Har Hotzvim 97774 (IL)**

(72) Inventors:
 • **REISFELD, Renata
 Jerusalem 92422 (IL)**
 • **SHMUELI, Eitan
 Ramat Gan 52681 (IL)**

 • **SARAIDAROV, Tsiala
 Ashdod 77625 (IL)**
 • **LEVCHENKO, Viktoria
 Jerusalem 93781 (IL)**
 • **LEIKOVICH, Amnon
 Tel Aviv 69414 (IL)**

(74) Representative: **Forstmeyer, Dietmar et al
BOETERS & LIECK
Oberanger 32
80331 München (DE)**

(56) References cited:
**WO-A1-00/54340     WO-A2-2004/022637
DE-A1-102005 043 572     US-A- 4 173 495
US-A- 4 227 939     US-A1- 2008 149 165**

## Description

### FIELD OF THE INVENTION

The present invention relates to methods for producing a luminescent solar concentrator (LSC). More specifically, the present invention relates to a method for producing an LSC incorporating an organic-inorganic sol-gel composite film doped by luminescent dyes providing high efficiency and stability

### BACKGROUND OF THE INVENTION

The World's conventional energy supplies, based mainly on readily available fossil sources, are rapidly diminishing. The main short-term alternative to the energy crisis, nuclear fission energy, raises a tremendous amount of controversy, and the date of the practical realization of nuclear fusion is not yet known. There is no doubt that solar energy being a clean and non-hazardous source, could provide a considerable contribution to solving the energy problem, if proper methods are developed to collect, concentrate, store, and convert the solar light which is diffuse and intrinsically intermittent. The feasibility of solar photovoltaic cells represents a security net in countries without sufficient hydroelectric power in the quite conceivable situation of strong political reluctance to construct nuclear reactors. Nevertheless, it is clear that it would be a decisive advantage if the amount of silicon needed per kW could be cut by a factor of 5 or 10, if only for the reason that the preparation of doped high-grade silicon itself needs exceedingly large amounts of electrical energy.

One way of concentrating solar light involves parabolic mirrors (or an assembly of such reflecting surfaces used for solar furnaces) or Fresnel lenses, which would be favorable for gallium arsenide (GaAs) photovoltaics. However, it is expensive to install the heliostat-type equipment needed for tracking of the daily apparent motion of the sun, and one loses almost the entire amount of diffused light which constitutes about 60% of the light reaching the earth's surface in Europe and in most regions of USA.

The principle of the planar luminescent concentrator was first proposed by Weber and Lambe[1]and then elaborated in greater detail simultaneously by Goetzberger and Greubel[2] and by Swartz, Cole and Zewail[3]. The subject has been further analyzed by Batchelder, Zewail and Cole[4-5] and by Goetzberger and Wittwer[6] with emphasis on the use of fluorescent organic dye-stuffs. Reisfeld et al, describes that the uranyl ion works in inorganic glasses[7] although addition of trivalent neodymium or holmium increases the yield[8]. In ref.[9-11] we proposed to use sol-gel glass based on silica doped by dyes for concentration of solar energy. However, so far, only very low efficiency of energy outcome has been observed.

WO 00/54 340 A1 discloses a radiation concentrator for a photovoltaic device. US 2008/149165 A1 discloses a luminescent solar collector.

### DETAILED DESCRIPTION OF THE INVENTION

In solar applications, materials such as glass and plastics have been used to minimize thermal losses, concentrate and focus light, and protect absorbers. Plastics as compared with glass, are less expensive, more easily formed into complex shapes, lighter in weight and not as brittle. Accordingly, the use of plastics, such as polycarbonates and acrylic polymers, is increasing in solar applications, however, these have to be treated and protected since it is commonly known in the art, that polycarbonates and acrylic polymers are photosensitive and degraded when exposed to UV radiation.

### Organic-inorganic sol-gel composite matrix.

Sol-gel coating film is known as simple and inexpensive. More particularly, the sol-gel method is a low-temperature technique for creating solid glass bulks or thin films. Using this method, coatings on glass, ceramic, metal or other solid substrates are easily fabricated. In addition, the relatively gentle synthetic conditions allow for the addition of various dopants such as organic dyes or inorganic ions, which convert the resulting glass/dopant combination into an active material which may be used in various optical or sensing applications.

The sol-gel method allows for the preparation of transparent and porous inorganic matrices and the incorporation of organic molecules in its porosity. The method involves reactions of hydrolysis and condensation of silicon alkoxides to produce a 3-D, amorphous, porous and stable silica network. Organically modified siloxane matrices, especially those with large organic modifiers, are the preferred materials which allow for the introduction of large amounts of organic molecules.

In the present invention, there are used sol-gel composite hybrid materials based on various alkoxides, such as TEOS or TMOS, GLYMO, PhTMOS, ICPTMOS,PEG TPOZ; The important component of the coating is composite DURS (synthesized separately using ICPTMOS and PEG) providing elasticity and flexibility of the coating. TPOZ is used as a modifier for film refractive index and as an efficient catalyst for the epoxy polymerization. Large organic modifiers in the matrix (phenyl groups in PhTMOS precursor) are used to screen the strongly polar silanol groups of the surface of the pores.

**BRIEF SUMMARY OF THE INVENTION**

More specifically, the present invention is directed to a method of producing a luminescent solar concentrator, comprising at least one plate having two major surfaces and a plurality of edges having solar cells attached thereto, said plate comprising a substrate selected from the group consisting of glass and plastic and being provided with a composite inorganic-organic sol-gel based matrix film deposited on at least one major surface thereof, wherein said film is doped with at least one luminescent dye and with silver spheroid nanoparticles of a size in the range of 8 to 60 nm, for increasing the luminescence intensity provided by said dye, and wherein said concentrator comprises at least three luminescent dyes of substantially different absorption ranges and wherein said film has a thickness of at least 10 $\mu$m, characterized in that the method comprises the step of producing said silver spheroid nanoparticles by the reduction of silver nano-particles *in situ* in a hybrid composite ormosil sol-gel solution forming a matrix using silver nitrate and dimethylformamide. Thus, an organic-inorganic sol-gel composite coating doped by luminescent dyes providing high efficiency and stability and used for a luminescent solar concentrator. The coating is an optical clear glass material based on organically modified siloxanes (ormosils) and formed by a sol-gel process. The sol-gel matrix includes composite hybrid materials, such as di-urethane-siloxane (DURS) (synthesized separately from Isocianato-propyl-trimethoxy-silylane (ICPTMOS) and Polyethylene glycol (PEG)), providing elasticity and flexibility of the coatings. The sol-gel coating is based on various alkoxides such as: tetra-ethoxy-silane (TEOS); tetra-methoxy-silane (TMOS); glycid-oxypropyl-trimethoxy-silane (GLYMO); phenyl-trimethoxy-silane (PhTMOS); and zirconium-n-tetrapropoxide (TPOZ).

Thermo stable and highly efficient luminescent dyes, such DFSB-K82-Yellow; DFSB-K-61-Clear Blue; DFWB-K1-60-Orange; Rhodamine 640; Rhodamine Red; and Rhodamine B, are used in single, double, triple or quadruple doped composite film, absorbing in the visible range, taking into account the solar spectrum, and emitting at longer wavelengths thereby decreasing self absorption.

Enhancement of luminescence emission occurs as a result of the incorporation of luminescent dyes and synthesized silver nanoparicles into the novel composite ormocer matrix.

The composite film, doped by silver spheroid nano-particles sized in the range of 10-40nm, provide an intensification of luminescence due to surface plasmon resonance. The present invention includes the novel crystal growth process of silver nanoparticles obtained by sol-gel process. Reduction of silver NP's was performed in situ in hybrid composite ormosil sol-gel solution using silver nitrate and dimethyl-formamide (DMF). The hybrid composite matrix involves di-urethane terminated silica network which acts as a stabilizing and coupling agent. In this way it is possible to obtain various sizes and shapes of silver NPs. Silver NPs exhibit a strong characteristic extinction peak, due to plasmon resonance occurring in the range of 400-410nm.

More specifically the present invention includes silver nanoparticles synthesized in sol-gel media and incorporated in composite films.

Intensification of luminescence intensity increases the efficiency of the LSC. A film-coating containing strongly absorbing and highly fluorescent dyes, is in contact, around its perimeter, with a set of photovoltaic cells (PVCs). Light absorbed by the dye is reradiated as fluorescence. Due to total internal reflection at the surfaces of the LSC, fluorescence emerges from the thin edge of the sheet and strikes the PVCs. Thus, the glass or plastic sheet acts as an optical trap and as a 2-D light pipe to the PVCs.

The coating has a predetermined refractive index equal to that of the substrate such as glass (or plastic) and uniform maximum thickness in the range of 30-35mkm. The coating is deposited on the glass substrate using a drop-casting method, is kept at room temperature for 48 hours and is then dried at 30°C, preferably 50°C and most preferably at 70°C for 24 hours.

The LSC concentrates the emitted fluorescent light to a small area at the edge of the plate deposited on the sheet, to which photovoltaic cells can be attached. The reported luminescence solar concentrators with quantum efficiencies exceeding 70% and projected power conversion efficiencies show as high as 12-23% efficiency in terms of percent of radiation energy reaching the surface of the plate versus the output energy measured and calculated from the LSC as described hereinafter.

A strip of silicon cell having an area 1/33 of the surface of the plate and having a 17% efficiency rating was glued with clear epoxy to one of the edges and was exposed in a sun simulator. A short circuit current was measured, and was then multiplied by 4 (to account for 4 available edges). The result was compared to that of a calibrated cell covering the entire surface of the plate and having a measured 17% efficiency rating. The results showed that with a single LSC (comprising a mixed dye and non stacked concentrator) we have reached 12.59% efficiency with an area which is only 1/8 that of the calibrated cell, and with a 3 stacked concentrator, each one absorbing a different part of the solar spectrum, based on the same measuring method, the result showed 23.5% efficiency.

The predicted results of power-conversion efficiencies based on expensive GaAs and GaInP solar cells that was discussed in ref.19 were only 6.8%.

In contrast the results presented here based on measured power-conversion efficiencies with silicon cells surpassed 23.5%.

## STATEMENTS OF INVENTION

The present invention provides a method of producing a luminescent solar concentrator, comprising at least one plate having two major surfaces and a plurality of edges having solar cells attached thereto, said plate comprising a substrate selected from the group consisting of glass and plastic and being provided with a composite inorganic-organic sol-gel based matrix film deposited on at least one major surface thereof, wherein said film is doped with at least one luminescent dye and with silver spheroid nanoparticles of a size in the range of 8 to 60 nm, for increasing the luminescence intensity provided by said dye, and wherein said concentrator comprises at least three luminescent dyes of substantially different absorption ranges and wherein said film has a thickness of at least 10 $\mu$m, characterized in that the method comprises the step of producing said silver spheroid nanoparticles by the reduction of silver nanoparticles *in situ* in a hybrid composite ormosil sol-gel solution forming a matrix using silver nitrate and dimethylformamide. The luminescent solar concentrator (LSC) produced according to the method of the present invention is one exhibiting high efficiency, and durable fluorescence properties, comprising at least one plate having two major surfaces and a plurality of edges having solar cells attached thereto, said plate comprising a substrate selected from the group consisting of glass and plastic and being provided with a composite inorganic-organic sol-gel based film deposited on at least one major surface thereof, wherein said film is doped with at least one luminescent dye and said concentrator comprises at least three luminescent dyes of substantially different absorption ranges and wherein said film has a thickness of at least 10 $\mu$m.

In especially preferred embodiments of the present invention said sol-gel film has a thickness of at least 20 $\mu$m and in the most preferred embodiments of the present invention said sol-gel film has a thickness of between about 30-50$\mu$m.

Preferably said LSC comprises at least one film doped with a luminescent dye and with silver spheroid nano particles of a size in the range of 8-60 nm, for increasing the luminescence intensity provided by said dye.

In preferred embodiments of the present invention, said LSC comprises at least one plate as defined, said plate being provided with a composite inorganic-organic sol-gel based, fluorescent dye doped film, deposited on both major surfaces thereof.

In especially preferred embodiments of the present invention said LSC further comprises a porous anti-reflecting coating deposited as an upper layer thereof for diminishing the reflectance of solar light from 8% to less than 1 %.

In some preferred embodiments of the present invention said LSC comprises at least one plate as defined, said plate being provided with a composite inorganic-organic sol-gel based film deposited on at least one major surface thereof, wherein said film is doped with at least two fluorescent dyes.

Preferably said LSC further comprises a diffused reflector positioned adjacent an underside thereof to reflect back non-absorbed light which will be subjected to additional exposure in the LSC.

In preferred embodiments of the present invention said LSC is provided with a plurality of luminescent dyes which absorb the energy of solar spectrum in the range of between 350 and 600nm.

In especially preferred embodiments of the present invention said at least one luminescent dye is monomolecularly dispersed in a glymophenylsilica-polyurethane matrix film.

As stated above, the preferred LSC's are based on a combination of at least three luminescent dyes.

In some preferred embodiments of the present invention a plurality of different luminescent dyes are monomolecularly dispersed in the same glymophenylsilica-polyurethane matrix film and applied to a substrate glass or polymer plate.

In other preferred embodiments of the present invention there is formed a stack of at least three individual plates, each of which has a single or a plurality of different luminescent dyes monomolecularly dispersed in a glymophenylsilica-polyurethane matrix film, each dye-doped film being individually applied to a component substrate glass or polymer plate of said stack.

In preferred embodiments of the present invention the amount of dye present in each matrix film is between 0.1 and 0.2g/m$^2$.

In especially preferred embodiments of the present invention the amount of dye present in each matrix film is between 0.13 and 0.17g/m$^2$.

In especially preferred embodiments of the present invention said diffused reflector is a substantially white reflector positioned adjacent an underside of said LSC.

The main advantages of the LSC are:

- High concentration of light without tracking.
- High collection efficiency of diffuse light. If the incoming radiation is "misdirected" by arriving under an angle $\phi$ on the plate, the trapped flux is only multiplied by (sin $\phi$) which is still 0.9848 for $\phi$ = 80° and 0.9397 for $\phi$ = 70° representing typical values of misdirection.
- Good heat dissipation from large areas of the LSC plate in contact with air, preventing unnecessary heating of the converter device, which heating is known to have deleterious effects on silicon cells.
- Choice of the luminescent species allows optimization of the concentrated light to the maximum spectral sensitivity of the light-converting device (which may perform photochemical reactions other than that of a photovoltaic cell, e.g., a photosynthesis process).
- The relatively low efficiency of solar cells exposed to white light can be circumvented by using LSC as beam splitters and couple them to photovoltaic cells with optimum sensitivities in different spectral ranges, and hence use the solar spectrum in a more efficient fashion.

**Quantitative Considerations**

The total efficiency of a LSC is governed by the following physical loss factors:

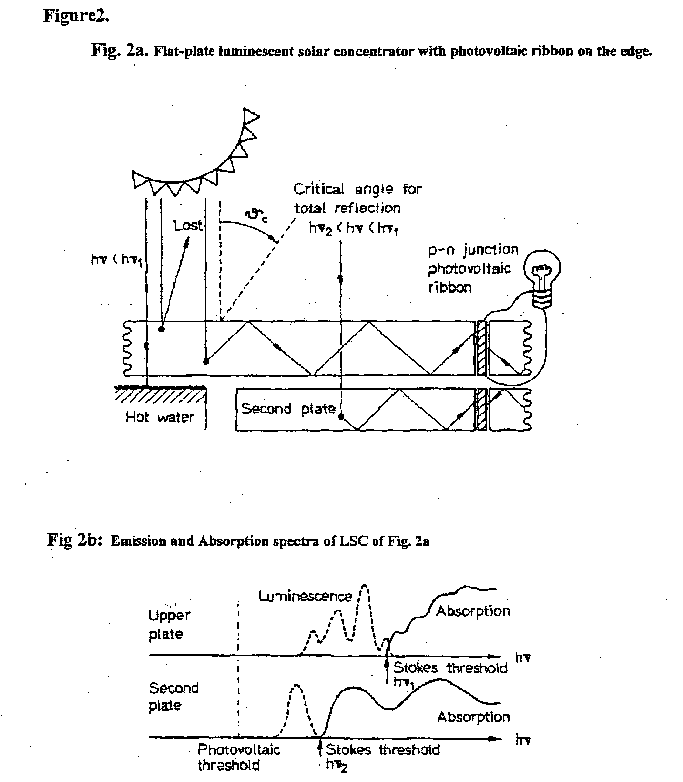

Critical cone loss corresponds to the fraction $\cos\theta_c$ of the isotropic luminescence passing through the spherical shell (with differential volume 4 $n$ $r^2$ dr with the fluorescent species at the centre) which undergoes consecutive total reflections (see Fig. 2) by being emitted outside the critical cone. Hence,

$$L = 1 - \cos \vartheta_c = 1 - ((n^2 - 1)/n^2)^{1/2} \qquad (1)$$

$$\vartheta_c = \arcsin (1/n), \text{ frequently called } \sin^{-1}(1/n) \qquad (2)$$

$$\sin \vartheta_c = 1/n$$

where n is the refractive index of the isotropic LSC plate. An example of trapping efficiencies of the plates with various refractive indices is shown below:

$$
\begin{array}{lllll}
n & = 1.414 & 1.556 & 1.743 & 2.000 \\
\vartheta_c & = \ \ 45° & 40° & 35° & 30° \qquad (3)\\
\eta_{trap} & = 0.7071 & 0.7660 & 0.8191 & 0.8660
\end{array}
$$

As can be seen, with increase of refractive index, the trapping efficiencies increases correspondingly.

It is to be further noted that in publication 19, by MIT, a glass plate with the refractive index of 1.7 was used, and the predicted efficiency was 6.8%, while in the present invention a glass plate with a refractive index of 1.523 was used with a measured efficiency of 12 - 23% depending on the configuration of the LSC as described hereinbefore.

Absorption efficiency $\eta_{abs}$ is the fraction of incident solar photons absorbed by the luminescent species. The solar photons here occur in direct and diffuse light. In most calculations, air-mass 1 (AM 1) is taken as standard but it should be noted that the detectable solar flux depends strongly on the atmospheric conditions.

If the energy flux per wave-number V (v) is divided by the photon energy $hv$ at that wave-number (= hcv), the total photon flux N(v) is obtained in the unit photons/m²s (cm⁻¹). The total flux of energy and of photons is given by the integration

$$I = \int\limits_0^\infty V(\bar{\nu})\, d\bar{\nu} = hc \int\limits_0^\infty \bar{\nu} N(\bar{\nu}) d\bar{\nu} \qquad (4)$$

where the integration limits of zero and infinity do not imply that V and N may not vanish over large regions.

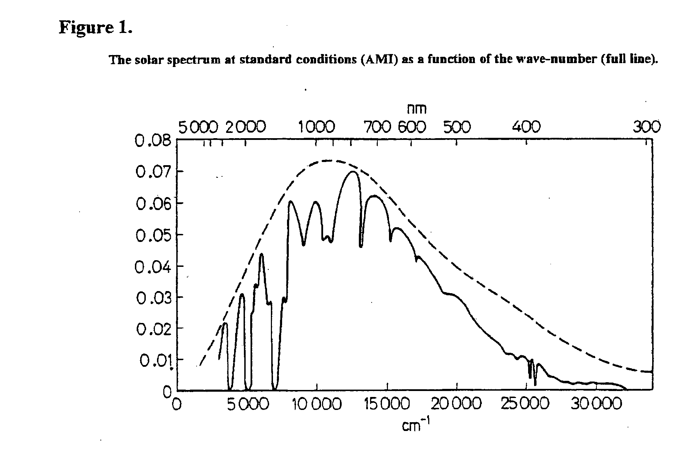

If a typical semiconductor is considered, it has an energy gap (e.g.) below which no absorption occurs. The solar spectrum (cf. Fig. 1), after passage through the ozone layer of the outer atmosphere, has a higher limit (cut-off) co.= 34000 cm$^{-1}$. By combining these two practical limits, we obtain an *efficient photon flux:*

$$I_{eff} = \int\limits_{E.g.}^{c.o.} N(\bar{\nu}) d\bar{\nu} \qquad (5)$$

A correction for angular distribution of the incident solar light should be considered. The normalized function U $(\theta, v)$ depends on the angle of incidence of sunlight on the LSC surface. When such a correction is introduced, the total *incident photon flux* $I_t$ becomes

$$I_t = \int\limits_0^\infty d\bar{\nu} \int\limits_0^{\pi/2} N(\bar{\nu})\, U(\vartheta_i, \bar{\nu}) \sin \vartheta_i \cos \vartheta_i\, d\vartheta_i \qquad (6)$$

with the normalization condition:

$$1 = \int\limits_0^\infty d\bar{\nu} \int\limits_0^{\pi/2} U(\vartheta_i, \bar{\nu}) \sin \vartheta_i \cos \vartheta_i\, d\vartheta_i \qquad (7)$$

The amount of light absorbed by the luminescent centers depends on an absorption coefficient for this center,

$$\alpha(\bar{\nu}) = 2.3026 \cdot c_M \cdot \varepsilon(\bar{\nu}) \qquad (8)$$

where 2.3026 is the natural logarithm of 10, $c_M$ is the molar concentration (moles/dm$^3$) of the luminescent center, and $\varepsilon(v)$ is the molar extinction coefficient as a function of the wave-number.

The amount S of solar photon flux that is absorbed by the colorant per unit area is defined (integrated from zero to the ozone cut-off):

$$S = \int\limits_0^{c.o.} d\bar{\nu} \int\limits_0^{\pi/2} N(\bar{\nu})\, U(\vartheta_i, \bar{\nu}) \sin \vartheta_i \cos \vartheta_i \cdot T(\vartheta_i, \bar{\nu}) \cdot \frac{\alpha(\bar{\nu})}{\alpha_t(\bar{\nu})} [1 - \exp(-\alpha_t(\bar{\nu})l_s]\, d\vartheta_i \qquad (9)$$

This is the incident solar photon flux from Eq. (6) times the transmission coefficient (for entering the LSC) $T(\theta_h v)$ times the fraction $a(v)/a_t(v)$ defining how much of the absorbed flux is absorbed by the colorant, times the total absorption probability integrated over all angles of incidence and wave-numbers. $l_s$ is the path-length by the solar flux inside the LSC. The efficiency of absorption of useful solar photons (having energy higher than the band gap of the semiconductor) is

$$\eta_{abs} = S/I_t \qquad (10)$$

The luminescence efficiency $\eta'_{lum}$ is defined as the ratio between the number of photons emitted and the number of photons absorbed. By the same token, just as $\eta'_{abs}$ is the ratio between two integrals over a wave-number range, $\eta'_{lum}$ also involves a weighting over energy of the incoming photons, if the quantum yield of luminescence is not invariant with wave-number.

The quantum efficiency $\eta'$ at a given wave-number of incoming photons is defined as the sum of probabilities of radiative transitions from the excited level $\Sigma Aj$ divided by the sum of radiative and non-radiative transitions probabilities

$$\eta = (\Sigma A_i)/(\Sigma A_i + W_{nr}) \qquad (11)$$

Finally, an efficiency $\eta'_{par}$ (which is less than one) is due to parasitic losses composed of self-absorption of the fluorescence by the emitting centers, absorption and scattering by chemical and structural imperfections. As discussed below, a special case is absorption due to a quasi-stationary concentration of excited states (such as triplet states of organic dye-stuffs) maintained by the illumination.

The *photon flux gain* in the LSC can then be defined

$$G_f = \frac{A_f}{A_e} \eta_{trap} \eta_{abs} \eta_{lum} \eta_{par} \qquad (12)$$

where $A_f$ is the surface area of the collector and $A_e$ is the edge area.

The flux gain $G_f$ is the multiplicative factor representing the increase in the usable photon flux delivered from the LSC to the photovoltaic cell, as compared to the flux received directly on the same photovoltaic surface turned perpendicular on the solar rays.

The *collector electric efficiency* is the ratio between the electrical power collected at the edge of the LSC and the power from the same photovoltaic material, when covering the surface of the LSC. For practical purpose a set of definitions recently proposed by Friedman[12] are quite useful:

> The *plate efficiency* is the ratio between the radiant power emitted at the edge of the collector to the power incident on the surface of the collector. This quantity is needed for comparing the operation of different plates.

The *collector efficiency* is the ratio between the electrical power collected from the photovoltaic cell put on the edges of the collector and the incident radiant power falling on the surface. Collector efficiency is the product of the plate efficiency and the efficiency of the photovoltaic cell. This ratio is useful for the economical evaluation of differing collectors.

*Cell edge efficiency* is the efficiency of the photovoltaic cell at the actual edge, power density, edge emission wave-length and edge radiant intensity distribution of the LSC.

*The relative solar absorption* is the fraction of the solar photons absorbed by the colorant.

The *plate luminescence efficiency* is the ratio between the plate efficiency and the relative solar absorption.

*Effective concentration ratio.* This value permits comparison of the performance of LSC with the conventional optical concentrators. This ratio expresses the number of equivalent suns under AM 1 conditions concentrated by the LSC.

The *relative edge power density* is the output in mW/cm² from the edge of radiant power at the emission wave-length under illumination by an incident (white light) power density of 100 mW/cm² (= 1 kW/m²) under AMI conditions. Below is a characteristic set of data taken from Ref. 12.

| | | | |
|---|---|---|---|
| Plate efficiency | 0.12 | Plate luminescent efficiency | 0.34 |
| Collector efficiency | 0.025 | Relative solar absorption | 0.21 |
| Cell efficiency | 0.21 | Effective concentration ratio | 1.6 |
| Cell fill factor | 0.73 | Edge emission wavelength | 630 nm |
| Incident solar flux | 101 mW/cm² | Relative edge power density | 130 mW/cm² |

It is realized today that in order for an LSC device to be efficient, one of the major requirements is that a great part of the solar spectrum (Fig. 1) should be absorbed, and that a large Stokes shift is needed between the absorption and the emission in order to prevent appreciable self-absorption of the luminescence. Another requirement involves a thermo-dynamical limitation of flux concentration which may be expressed by the inequality where $B_1$ is the brightness of the incident radiation field and $B_2$ for the emitted field. $v_x$ and $v_2$ are the frequencies of the incoming and outgoing photons, their difference representing a Stokes shift. Since for many reasons, the concentration factor *(BJBi)* is not expected to go beyond 100, Eq. (13) does not have dramatic consequences, as long the last parenthesis is well above 5, corresponding to the Stokes shift 1000 cm"[1] at room temperature.

A multi-stack device should consist of several plates arranged in such a way that the top plate absorbs the shortest wave-length radiation, which is then emitted as longer wavelength fluorescence. The consecutive total reflections transport this light to the edge, where it may activate a photovoltaic cell with a relatively high energy gap such as CdTe or a mixed aluminium-gallium phosphide-arsenide. The lower plates absorb at increasing wave-lengths, and their luminescent species emit further down in the red or infra-red. In principle, the last plate emitting photons of the lowest energy (cf. Fig. 2) might be coupled to a germanium photovoltaic. An advantage of multi-stack LSC is that about half of the radiation emitted within the critical cone can be recovered by the next plate just below[11].

ᵣe theoretical treatment of such a device, assuming no self-absorption connects the efficiency $i_{jQ}$ of the multi-stacked collector with the radiation collected at each stage $C_k = S_k(I - L)$. Here, $S_k$ is the radiation entering the k'th collector and L is the losses due to the critical cone. Hence, *TJQ* is the sum of the m differing $C_k$ values. For PMMA with the refractive index 1.49 the collection efficiencies for m plates are

| m = | 1 | 2 | 3 | 4 | 14 |
|-----|---|---|---|---|----|
| $\eta_Q$ = | 0.7126 | 0.7687 | 0.7793 | 0.7717 | |

showing that it is impracticable to make stacks of more than three plates, and that it is highly probable that two plates are the optimum choice.

The system efficiency can be calculated by multiplying the collection efficiency by the photovoltaic spectral response function, which can be obtained for a given photovoltaic cell from the short circuit current $i_L$ delivered to the load

$$i_L = qF\,(1 - R)\,(1 - e^{-al})\,\eta_{coll} \qquad\qquad (15)$$

As is known, the use of solar energy as a power source is not yet cost competitive with other power generating methods because of the high cost of solar cells and tracking solar energy concentrators. In an attempt to lower costs by reducing the cell area, in recent years, much work has been based on the concept of a luminescent solar concentrator which can absorb solar light from a large insolated area, i.e, from an area exposed to solar light, and concentrate the emitted fluorescent light to a small area to which photovoltaic cells can be attached. Luminescent solar concentrators (LSC) are based on the entrance of solar radiation into a homogeneous medium collector containing a fluorescent species in which the emission bands have little or no overlap with the absorption bands. This emission is trapped by total internal reflection and concentrated at the edge of the collector by the geometrical shape which is usually a thin plate. Thus the concentration of light trapped in the plate is proportional to the ratio of the surface area to the edges.

The concentrator for use with photovoltaic devices includes [13] a waveguide containing quantum dots. The quantum dots shift the solar radiation into the red part of the spectrum whereby the light is internally reflected within the waveguide. A photovoltaic device converts the red-shifted radiation to electrical energy.

The luminescent properties of core-shell quantum dots are being exploited in an unconventional solar concentrator which promises to reduce the cost of photovoltaic electricity. Luminescent solar collectors have advantages over geometric concentrators in that tracking is unnecessary and both direct and diffuse radiation can be collected.

Typically, LSC dye molecules are cast into a transparent plastic sheet [19], however, as reported in said research paper, a thin film of organic dye molecules was deposited onto glass. The devices were fabricated with thermal evaporation, but solution processing could also be used. These are planar waveguides with a thin-film organic coating on the face and inorganic solar cells attached to the edges. Light is absorbed by the coating and re-emitted into waveguide modes for collection by the solar cells. Said reference reported single- and tandem-waveguide organic solar concentrators with quantum efficiencies exceeding 50% and projected power conversion efficiencies only as high as 6.8%.

**Fluorescent dyes.**

High efficiently fluorescent dyes were incorporated in sol-gel ormocer composites: e.g., DFSB-K82-Yellow;

DFSB-K-61-Clear Blue; DFWB-K1-60-Orange; Rhodamine 640; Rhodamine Red; Rhodamine B;

The dyes were dissolved in Dimethylformamide with a dye concentration starting at 0.25% and incorporated in sol-gel composites.

**Silver nanoparticles**

Surface plasmons are collective oscillations of the electrons of conductors, and have attracted intense interest recently due to their wide range of potential applications. A light wave created at an interface between silver particles (plasmons) and a surrounding dielectric glass matrix induces a resonant interaction between the silver plasmons and the matrix resulting in a typical absorption curve. Metal nanoparticles can result in strong scattering of incident light and greatly enhance local fields, and can also lead to enhanced fluorescence. In the present invention it has been shown for the first time that there is a considerable increase in the luminescence intensity of dyes when they are in the presence of silver plasmons.

The present invention also provides for a new method of silver nanocrystal growth process involving the reduction of silver NPs in situ in hybrid ormosil sol-gel solution, to form a matrix using silver nitrate and dimethylformamide (DMF). The formed matrix is composed of a urethane terminated silica network, which acts as a stabilizing and coupling agent. The crystal growth process, particle size and shape, depend on the starting concentrations of silver ions and also on reaction time and temperature.

**Antireflective coating (ARC)**

A thin film of ARC deposited on an optical component can greatly reduce the optical loss, such as in multi-element lenses, by making use of phase changes and the dependence of the reflectivity on refraction index. Anti-reflection coatings are widely used in various applications such as display panels, solar cells and optical devices. The present invention preferably comprises a sol gel derived single layer antireflective coating (ARC) deposited as an upper layer on the LSC. The coated devices can be used in the field under potentially humid, corrosive, thermally and mechanically stressful environments. An ARC is comprised of a homogeneous, single layer porous coating on the solar cell surface, when the coating has a predetermined substantially single refractive index of 1.25-1.28 in the required spectral range, and a uniform thickness in the range of about between $0.25\mu m$ - $0.30\mu m$.

The optimum thickness and refractive index with a minimum reflectance for a single ARC layer can be deduced from the equation:

$$\lambda_0/4 = n\ t$$

where, $\eta_0$ is the midrange wavelength, n is the refractive index and t is the thickness of the ARC.

The optical component ARC comprises a coating layer consisting essentially of a silica inorganic porous skeleton, having hydrophobic organic groups covalently linked therein. In some cases, the organic groups are selected from the group consisting of methyl and ethyl or other alkyl groups. The method comprises, two steps of hydrolysis and polycondensation reactions, which are carried out at a constant temperature and two steps of thermal and chemical treatments.

**Optimizing Sol-Gel films for maximum absorption of suns radiation taking in consideration quenching and optimum optical performance.**

The cell can be attached at a 90 or 45 degree angle to the collector surface, whereby an angle of 45 degrees allows the cell to absorb direct light as well as concentrated light, thereby increasing the total surface efficiency

A selection of dyes with certain properties (as described in above table ) used to cover most of visible spectrum and UV spectrum, such that when used in combination, one dye's emission region is the next dye's excitation and absorption region, i.e., a short wave absorbing dye emits to the absorption area of the longer wavelength dye.

**Instrumentation:**

Absorption spectra were measured on JASCO-630 UV-Vis Spectrophotometer. Fluorescence spectra were measured on JASCO -FP-6200 Fluoremeter

While the invention will now be described in connection with certain preferred embodiments in the following examples so that aspects thereof may be more fully understood and appreciated, it is not intended to limit the invention to these particular embodiments. On the contrary, it is intended to cover all alternatives, modifications and equivalents as may be included within the scope of the invention as defined by the appended claims. Thus, the following examples which include preferred embodiments will serve to illustrate the practice of this invention, it being understood that the particulars shown are by way of example and for purposes of illustrative discussion of preferred embodiments of the present invention only and are presented in the cause of providing what is believed to be the most useful and readily understood description of formulation procedures as well as of the principles and conceptual aspects of the invention.

## Examples

The following examples are given as particular embodiments of the present invention, to illustrate some of the properties and demonstrate the practical advantages thereof;

## Preparation Example 1

The general range of sol-gel compositions (weight % oxides) is 54-66 $SiO_2$ and 46-34 $ZrO_2$; and with the ratio of organic/inorganic parts being 15.5-18.5/84.5-81.5;

The preparation of the sol-gel composite matrix of the present invention designated GPSPU-Zr-1 is as follows:

1.1 Preparation of the precursor sol-gel solution GPSPU-1 (glymo-phenylsilica-- polyurethane):

- Tetra-ethoxy silane (TEOS)          6ml,
- Phenyl tri-methoxy silane (PhTMOS)          2ml,
- Ethyl alcohol (EA)          50ml,
- Acetic Acid/Water=1:1          4 ml.
- DURS          5.0ml,
- Glymo          2.5ml,
- Ac. Acid glacial          1ml
- Phenoxy ethanol (Eph)          6ml,
- Stirring at room T=22°C for 24 hours, filtration and keeping in refrigerator.

1.2 Preparation of the precursor sol-gel solution of zirconia:

- Propanol          20ml,
- Zirconia tetra-propoxide          10ml,
- Acetic Acid glacial          4ml,
- Acetic Acid/D.Water=1/1          3.5ml,
- *Stirring at room T=22°C for 1 hours and filtration*

1.3 Preparation of the ormocer sol-gel composition solution GPSGU-Zr-1:

- *Precursor solution of GPSPU          30ml*
- *Precursor solution of Zirconia          9ml*
- *Stirring at room T=22°C for 1 hours and filtration*
- *Fluorescent dyes in appropriate solvent and quantities are added to the solgel composite.*

1.4 Preparation of single dye-doped sol-gel composition solution:

a) 0.15ml solution of Rhodamine 640 in DMF is added to 5ml of the composite solution of GPSPU-Zr-1and is stirred about 15minutes;

b) 0.5ml solution of DFSB-K82-Yellow in DMF is added to 5ml of the composite solution of GPSPU-Zr-1and is stirred about 15 minutes;

c) O.5ml solution of Rhodamine Red in DMF is added to 5ml of the composite solution of GPSPU-Zr-1and is stirred about 15 minutes;

d) O.5ml solution of DFSB-K-61-Clear Blue in DMF is added to 5ml of the composite solution of GPSPU-Zr-1and is stirred about 15 minutes;

e) Each dye solution is deposited on glass substrate by drop-casting method using 6-8 ml on 100x100x3mm$^2$.

a) Film should be dried at room temperature (22°C) for 24hours, then 35°C for 24 hours, then 45°C for 6 hours and then 70°C for 1 hour.

1.5 Preparation of multi-dyes-doped sol-gel composition solution:

a) 0.35ml solution of Rhodamine 640 and O.175ml solution of Rhodamine Red are added to 5ml of the composite solution of GPSPU-Zr-1 and is stirred about 15 minutes;

b) 0.35ml solution of Rhodamine 640, 0.175ml solution of DFSB-K82-Yellow and O.175ml solution of Rhodamine Red are added to 5ml of the composite solution of GPSPU-Zr-1and is stirred about 15 minutes;

c) 0.5 ml solution of DFSB-K82-Yellow and 1.0 ml solution of DFSB-K-61-Clear Blue are added to 5ml of the composite solution of GPSPU-Zr-1 and is stirred about 15 minutes;

d) Each dye solution is deposited on glass substrate by drop-casting method using 6-8 ml on 100x100x3mm$^2$.;

e) Film should be dried at room temperature (22°C) for 24hours, then 35°C for 24 hours, then 45°C for 6 hours and then 70°C for 1 hour.

The Refractive Index of the deposited film on the glass substrate plate is 1.523. The thickness of the deposited film is 34.5 micron.

**Preparation Example 2.**

2.1. Preparation of the precursor sol-gel solution GPSPU-2 (glymo-phenylsilica-polyurethane):

- Tetra-ethoxy silane (TEOS)          6ml,
- Phenyl tri-methoxy silane (PhTMOS)        2ml,
- Ethyl alcohol (EA)        50ml,
- Acetic Acid/Water=1:1        4 ml.
- DURS          6.25ml,
- Glymo          2.5ml,
- Ac. Acid glacial          ml
- Phenoxy ethanol (Eph)          6ml,
- Stirring at room T=22°C for 24 hours, filtration and keeping in refrigerator.

2.2 Preparation of the ormocer sol-gel composition solution GPSGU-Zr-2:

- *Precursor solution of GPSPU-2          30ml*
- *Precursor solution of Zirconia          9ml*
- *Stirring at room T=22°C for 1 hours and filtration*
- *Fluorescent dyes in appropriate solvent and quantities are added to the sol-gel composite.*

2.3 .Preparation of multi-dyes-doped sol-gel composition solution GPSGU-Zr-2:

0.35ml solution of Rhodamine 640, 0.175ml solution of DFSB-K82-Yellow and O.175ml solution of Rhodamine Red are added to 5ml of the composite solution of GPSPU-Zr-2 and is stirred about 15minutes;

<u>2.4 Films produced as above are deposited on a glass substrate plate by drop-casting method using 6-8ml on a plate which is 100x100x3mm</u>

The Refractive Index of the deposited film on the glass substrate plate is 1.520.

**Example 1. Intensification of luminescence intensity of dyes in presence of silver plasmons incorporated in GPSPU-Zr-1.**

<u>3.1 Ag nanoparticles preparation in sol-gel solution:</u>

- Tetra-ethoxy silane (TEOS)     0.01M,
- DURS     0.005-0.01 M
- Ethyl alcohol (EA)     0.2M,
- DMF     0.05-0.5M
- Distilled water(DW)     2.0ml
- Silver nitrate     0.001 M

The alkoxides are hydrolyzed for 30 min and refluxed at boiling temperature, the obtained yellow-brownish colloidal solution is cooled and kept in refrigerator.

<u>3.2 Preparation of dye-doped sol-gel composition solution in presence of silver nanoparticles:</u>

- Rhodamine B ($2*10^{-5}$M ) in EA is added to 5ml of the composite solution of GPSPU-Zr-1 and is stirred about 15minutes;
- Ag Nanoparticles obtained in sol-gel colloidal solution (3.1.) is added to dye doped sol-gel composites : $3*10^{-3}$; $4*10^{-3}$ and $5.4*10^{-3}$ M/L.
- Dye doped solution in presence of Ag NPs is deposited on glass substrate by drop-casting method using 6-8 ml on said glass substrate plate having dimensions of $100x100x3mm^2$..
- Film should be dry at room temperature (22°C) for 24hours, then 35°C for 24 hours, then 45°C for 6 hours and then 70°C for 1 hours,
- The compared graphs show 4-fold Intensification of fluorescence intensity by presence of $5.4*10^{-3}$ M/L Ag NPs.

**Preparation Example 3. Preparation of antireflective coatings:**

4.1. <u>First step:</u> 2ml of TEOS, and 0.7 ml MTMOS are dissolved in 14-15ml of EA and stirred using magnetic stirrer for 10min at the constant temperature of 20°C. (0.9ml of DW+0.1ml of $HNO_3$)- quantity of catalyst + DW solution added to TEOS+EA solutions and stirred during 60-65min.

<u>Second step:</u> Then 0.20ml-0.25ml HF added and stirred till the viscosity of the sol-gel solution increases to 2.5-2.6 cP.

4.2. <u>First step:</u> 2ml of TEOS, and 1.0 ml MTMOS dissolved in 17-18ml of EA and stirred using magnetic stirrer for 10min at the constant temperature of 20°C. (0.9ml of DW+0.1ml of $HNO_3$)- quantity of catalyst + DW solution added to TEOS+EA solutions and stirred during 75-90min.

<u>Second step:</u> Then 0.25-0.3ml HF added and stirred till the viscosity of the sol-gel solution increases to 2.5-2.6 cP.

4.3. <u>Dip-coating process:</u> AR coatings deposition is performed at 30, 40, 50 and 60 minutes after HF hydrolysis process started. The films are deposited on glass substrates by dip-coating technique with a withdrawal speed of 20 cm/min, and dried at 40°C for 1 h. Thermal treatment is performed at 150°C for 1 h.

4.4. <u>The post chemical treatment</u> of ARC coating is performed by 0.25 % of HF/ethanol solution for 10-20 min, then films are washed in distilled water, and dried at room temperature.;

4.5. <u>Thermal treatment performed</u> at 150°C for 30 min.

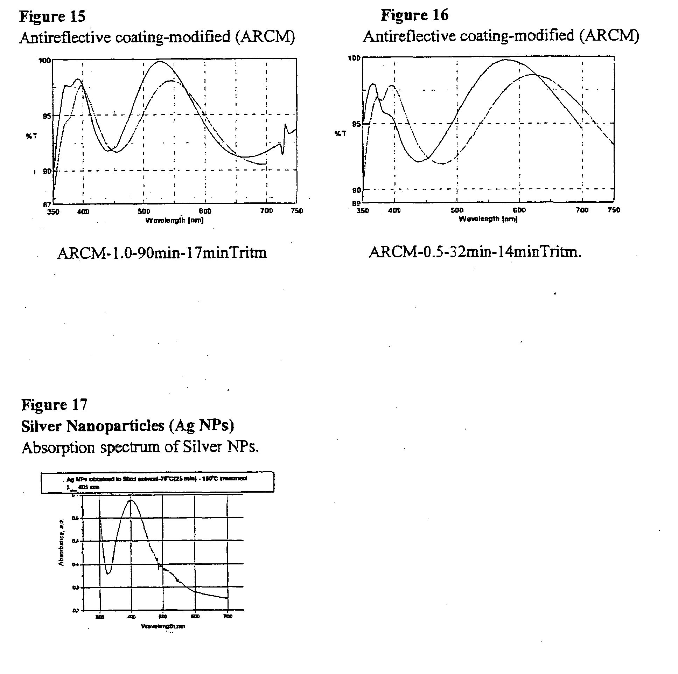

4.6. Figures 15 and 16 show transmittance of up to 99.5% for ARC coated substrate as opposed to a standard transmittance of 92% which is that of uncoated glass.

**EP 2 327 108 B1**

**Preparation Example 4: Preparation of LSC:**

One strip of a silicon cell was glued with clear epoxy to one of the four edges of a glass substrate prepared according to Preparation Example 1 said glass substrate plate being coated with a dye-doped sol-gel film to form an LSC, which was exposed in a Sun Simulator and a short circuit current was measured, and multiplied by 4 (4 available edges) and was compared to a calibrated cell based on area of exposure.

The results showed that with a single Mixed Dye LSC, i.e., a single plate wherein the matrix film was doped with three dyes, said dyes being Rhodamine 640, Rhodamine Red and DFSB-K82-Yellow absorbing different parts of the solar spectrum as shown in the table hereinbelow, there is reached 12.59% efficiency, while with a triple stacked concentrator, i.e., three plates according to Preparation Example 1, where each one is separately coated with a dye-doped glymophenylsilica-polyurethane matrix film as described in Preparation Example 1, and each film is formed with a different dye, the three dyes being used being Rhodamine 640, Rhodamine Red and DFSB-K82-Yellow absorbing different parts of the solar spectrum as shown in the table hereinbelow, the plate prepared as described herein showed 23.5% in efficiency.

In addition, in both of the experiments described herein, there was added a diffused reflector underneath the LSC to reflect back non-absorbed light to be absorbed by the silicon cell glued to the edge of the plate or plates and by the dyes in their respective ranges.

Table

| Dye | Solvent/ Matrix | Concentration (M) | $\lambda_{max}$ Absorbance, (nm/a. u.) | $\lambda_{max}$ Emission (nm/n. u.) | Radiative Life-time, (ns) | Natural Life-time, (ns) | Quantum Yield |
|---|---|---|---|---|---|---|---|
| PM 597 standard | EA | 2.5* 10-6M | 524/0.41 | 560/161 | 4.20 | 5.48 | 0.766 |
| Rhodamine 116 Perchlorate | GPSPU | - film | 535/0.078 | 553/44.7 | 3.98 | - | 0.667 |
| Rhodamine B | GPSPU | -film | 560/0.1 | 580/71 | 3.00 | - | 0.740 |
| Rhodamine 640 | GPSPU | -film | 581/0.21 | 598/194 | 4.86 | - | 0.765 |
| Rhodamine Red | GPSPU | -film | 535/1.34 | 556/1000 | 4.94 | - | 0.817 |
| DFSB-K82 (Yellow) | GPSPU | - film | 446/1.62 | 511/1000 | 3.22 | - | 0.949 |
| DFCB-K61 (Clear Blue) | GPSPU | - film | 379/2.4 | 435/1000 | 3.25 | - | 0.968 |

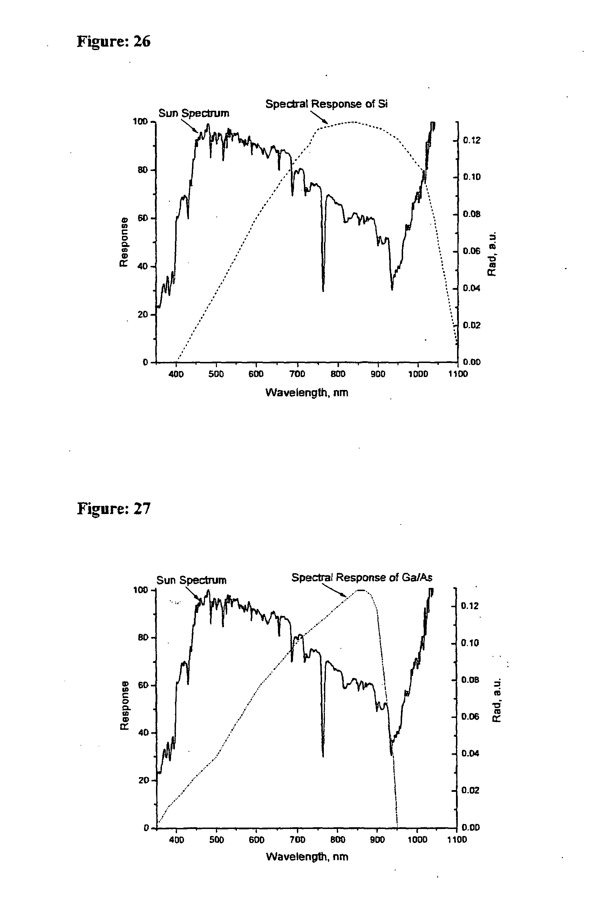

Referring to Figure 26 described hereinafter, there is provided a graph which shows the spectral response of a typical silicon based solar cell against the sun's spectrum, additionally it shows that the maximum sensitivity and response of silicon to the solar spectrum is where the sun's radiation intensity is low.

Thus it will be noted that silicon responds and gives off electricity mainly in the range of 600-1,000nm.

Referring to Figure 27, described hereinafter, there is presented a graph which shows the spectral response of a typical GaAs based solar cell against the sun's spectrum. Additionally it shows that the maximum sensitivity and response of GaAs to the solar spectrum is also where the sun's radiation intensity is low.

Thus it will be noted that gallium arsenide responds and gives off electricity mainly in the range of 600-900nm.

Thus neither gallium arsenide nor silicon are adapted to utilize solar spectrum wavelengths in the range of 400-600nm.

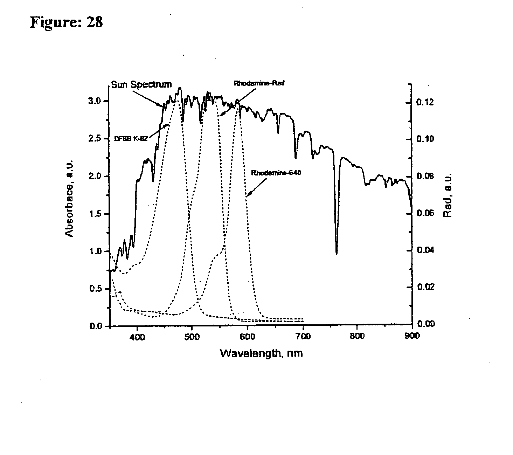

Referring therefore to Figure 28 and to the table hereinabove, one can see that dyes such as those in the yellow, orange and red spectrum can absorb and emit in the 350-600nm range, thereby utilizing the energy in said wavelengths. Additionally it shows that the selected dyes are absorbing where the spectrum intensity is the highest.

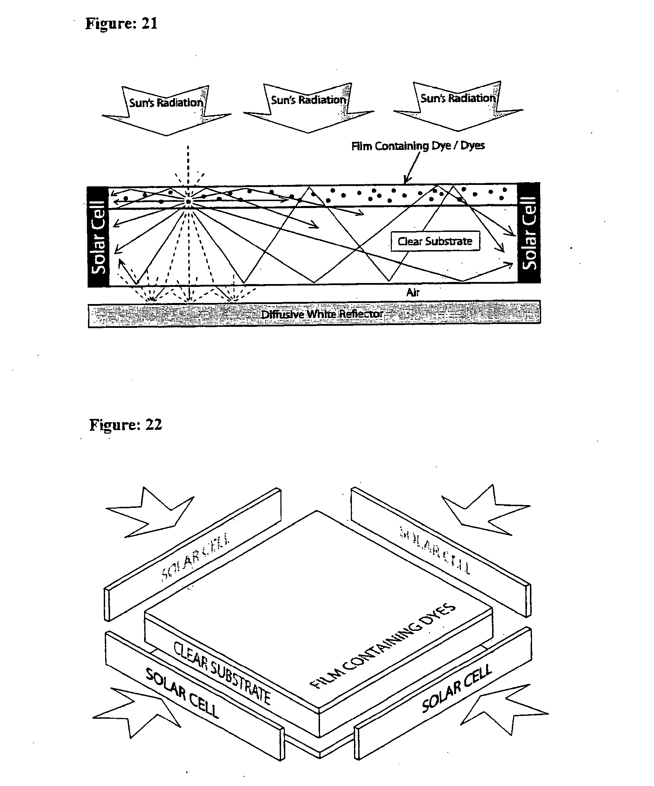

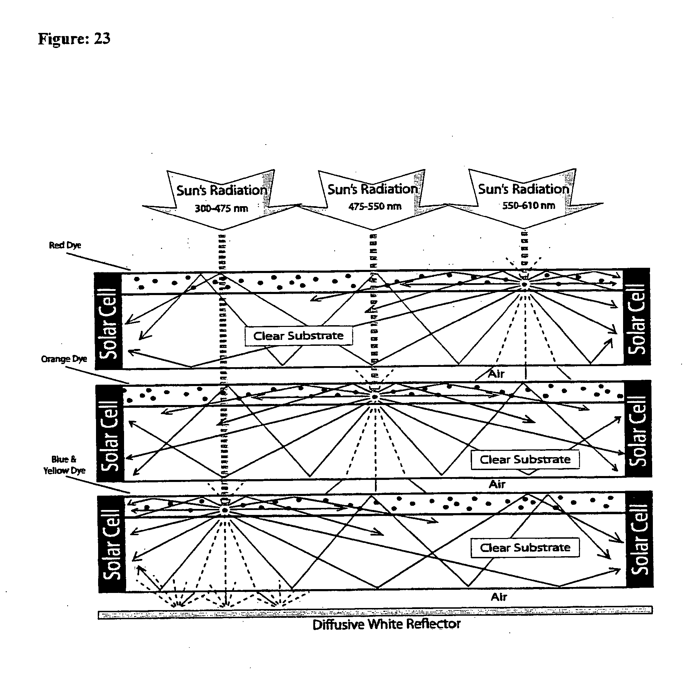

The novel construction of the LSC according to the present invention, as shown, e.g., with reference to Figures 21 and 23, enables the utilization of the solar spectrum energy in the 400-600 range by virtue of the dyes incorporated into the LSC and in preferred embodiments, the diffusive white reflector to reflect back non-absorbed light to be absorbed by the silicon cells glued to the 4 edges of the plate or plates, and by the dyes in their respective ranges, thereby increasing the efficiency of the LSC's of the present invention.

It is to be noted that the strips of silicon cells which are glued to the edges of the film coated plate, can be attached in a 90 or 45 degree angle to the collector surface. An attachment at 45 degrees will allow the cell to absorb direct light as well as concentrated light increasing total surface efficiency.

It is further to be noted that the measured result of 23.5% efficiency was achieved without the addition of an antireflective coating to the LSC and it is believed that the addition thereof will increase efficiency by another 2%.

The invention will now also be described in connection with certain preferred embodiments with reference to the following illustrative figures so that it may be more fully understood.

With specific reference now to the figures in detail, it is stressed that the particulars shown are by way of example and for purposes of illustrative discussion of the preferred embodiments of the present invention only and are presented in the cause of providing what is believed to be the most useful and readily understood description of the principles and conceptual aspects of the invention. In this regard, no attempt is made to show structural details of the invention in more detail than is necessary for a fundamental understanding of the invention, the description taken with the drawings making apparent to those skilled in the art how the several forms of the invention may be embodied in practice.

**BRIEF DESCRIPTION OF THE DRAWINGS**

Figure 1 is a graph depicting the solar spectrum at standard conditions (AMI) as a function of the wave-number (full line). The dashed curve is the continuous spectrum of an opaque object at 5750 K, very similar to the solar spectrum measured outside the atmosphere. However, on this scale of resolution, several solar Fraunhofer lines can be seen above 15 000 cm$^{-1}$. The unit is W/m$^2$ per cm$^{-1}$;

Figure 2a. is a schematic cross-sectional view of a flat-plate luminescent solar concentrator with photovoltaic ribbon on the edge showing photons with an energy below the Stokes threshold hv going directly through the upper plate;

Figure 2b is a schematic representation of a qualitative typical emission and absorption spectra;

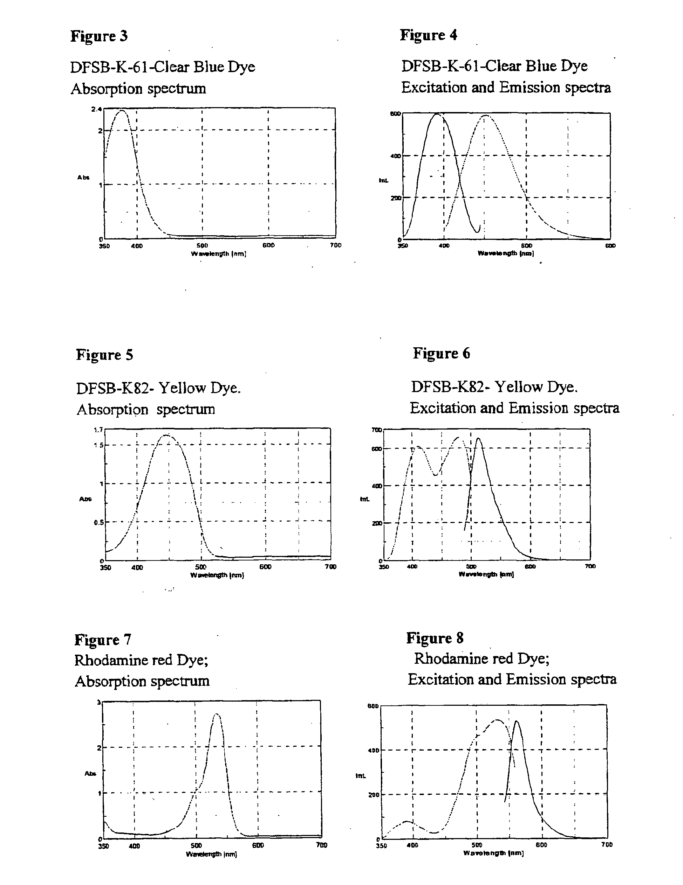

Figure 3 is a graphical representation showing the absorption spectrum of DFSB-K-61-Clear Blue dye incorporated in sol-gel composite matrix GPSPU-Zr-1 and deposited on a glass substrate;

Figure 4 is a graphical representation showing the excitation and emission spectra of DFSB-K-61-Clear Blue dye incorporated in sol-gel composite matrix GPSPU-Zr-1 and deposited on a glass substrate;

Figure 5 is a graphical representation showing the absorption spectrum of DFSB-K82-Yellow dye incorporated in sol-gel composite matrix GPSPU-Zr-1 and deposited on glass substrate;

Figure 6 is a graphical representation showing the excitation and emission spectra of DFSB-K82-Yellow dye incorporated in sol-gel composite matrix GPSPU-Zr-1 and deposited on glass substrate;

Figure 7 is a graphical representation showing the absorption spectrum of Rhodamine Red dye incorporated in sol-gel composite matrix GPSPU-Zr-1 and deposited on glass substrate;

Figure 8 is a graphical representation showing the excitation and emission spectra of Rhodamine Red dye incorporated in sol-gel composite matrix GPSPU-Zr-1 and deposited on glass substrate;

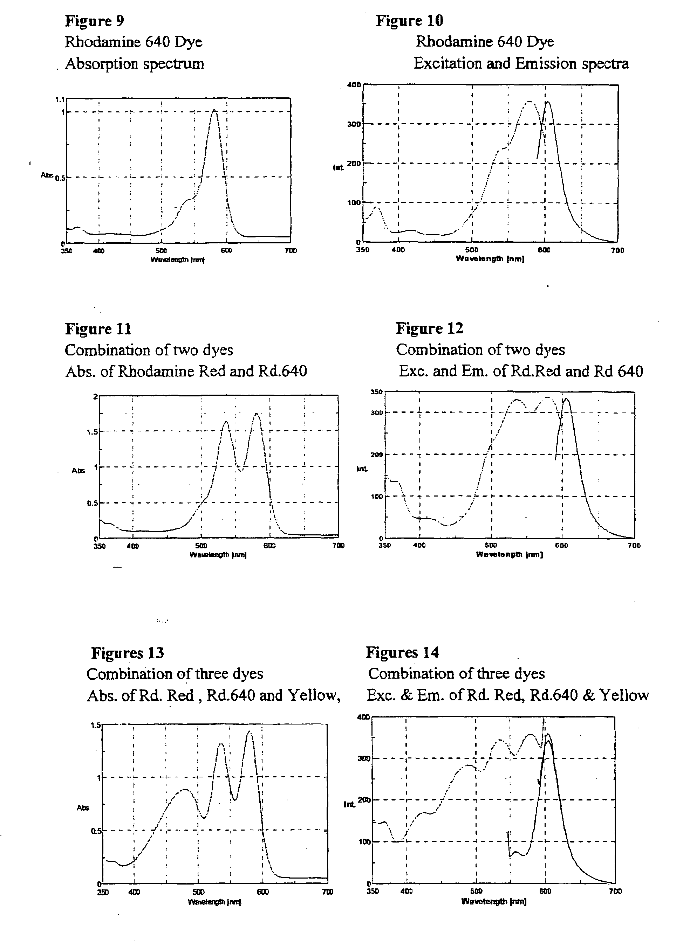

Figures 9 is a graphical representation showing the absorption spectrum of Rhodamine 640 dye incorporated in sol-gel composite matrix GPSPU-Zr-1 and deposited on glass substrate;

Figure 10 is a graphical representation showing the excitation and emission spectra of Rhodamine 640 dye incorporated in sol-gel composite matrix GPSPU-Zr-1 and deposited on glass substrate;

Figure 11 is a graphical representation showing the absorption spectrum of a combination of the dyes Rhodamine Red and Rhodamine 640 incorporated in sol-gel composite matrix GPSPU=Zr-1 and deposited on glass substrate;

Figure 12 is a graphical representation showing the excitation and emission spectra of the combination of dyes Rhodamine Red and Rhodamine 640 incorporated in sol-gel composite matrix GPSPU-Zr-1 and deposited on glass substrate;

Figure 13 is a graphical representation showing the absorption spectrum of a combination of three dyes; DFSB-K82-Yellow, Rhodamine Red and Rhodamine 640, incorporated in sol-gel composite matrix GPSPU-Zr-1 and deposited on glass substrate;

Figure 14 is a graphical representation showing the excitation and emission spectra of the combination of three dyes; DFSB-K82-Yellow, Rhodamine Red and Rhodamine 640,incorporated in sol-gel composite matrix GPSPU-Zr-1 and deposited on glass substrate;

Figure 15 - 16 show different examples of ARC-films deposited on glass substrate;

Figure 17 is a graphical representation of an absorption spectrum of Silver NPs;

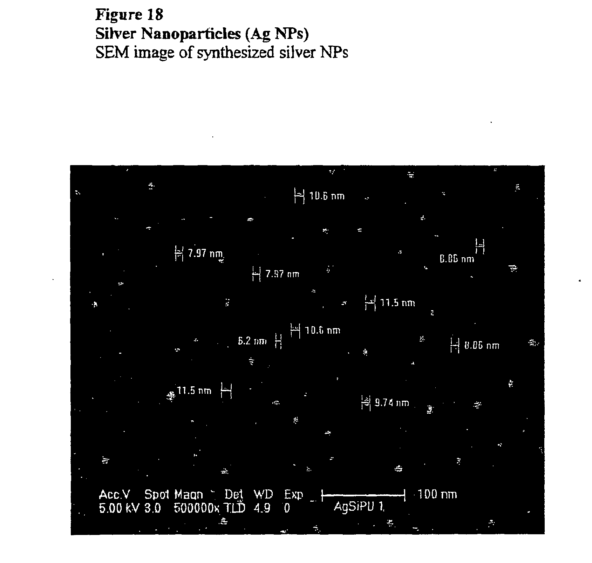

Figure 18 is a SEM picture of synthesized silver NPs with sizes of 6-12nm;

Figure: 19 is a graphical representation of an absorption spectra of Rd B-dye in GPSPU-ZR-1 matrix with and without Ag NPs;

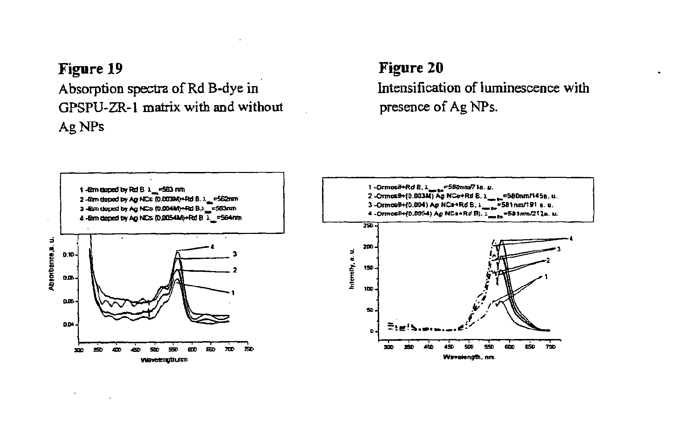

Figure 20 is a graphical representation of intensification of luminescence with the presence of Ag NPs;

Figure 21 is a cross-sectional view depicting a single LSC plate according to the present invention wherein the clear plate, i.e., the transparent plate, is provided with an upper sol-gel composite matrix film containing a dye and with a diffusive white reflector positioned below the plate assembly. In the figure we can see sun's light absorbed by the film containing dye, the dye emits light at a longer wave length. Light traveling above a critical angle is piped through the clear substrate due to a total refection and reaches the solar cells attached at the edges of the substrate. Light under critical angle exits the substrate and is reflected back by the diffused reflector;

Figure 22 is an exploded perspective view of the one layer LSC plate according to Figure 21;

Figure 23 is a systematic cross-sectional view depicting a three-plate LSC according to the present invention wherein each plate is provided with an upper sol-gel composite matrix doped with a different dye and a diffusive white reflector positioned below the plate assembly;

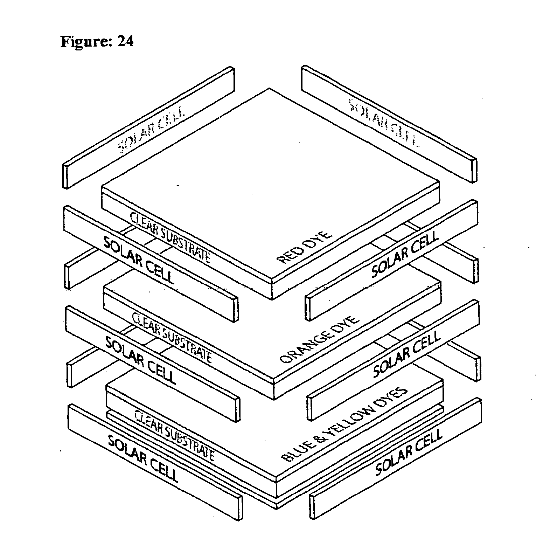

Figure 24 is an exploded perspective view of a three-place LSC according to the present invention;

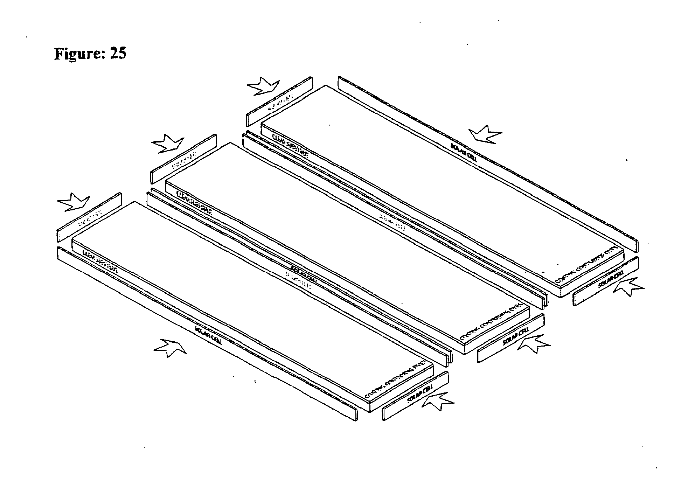

Figure 25 is an exploded perspective view showing a plurality of three plates in a rectangular array;

Figure 26 is a graphical representation of the wavelengths of the sun spectrum vis-à-vis the spectral response of Si.

Figure 27 is a graphical representation of the wavelengths of the sun spectrum vis-à-vis the spectral response of Ga/As;

Figure 28 is a graphical representation of the wavelengths of the sun spectrum vis-à-vis the spectral response and absorption of a combination of three dyes according to the present invention; and

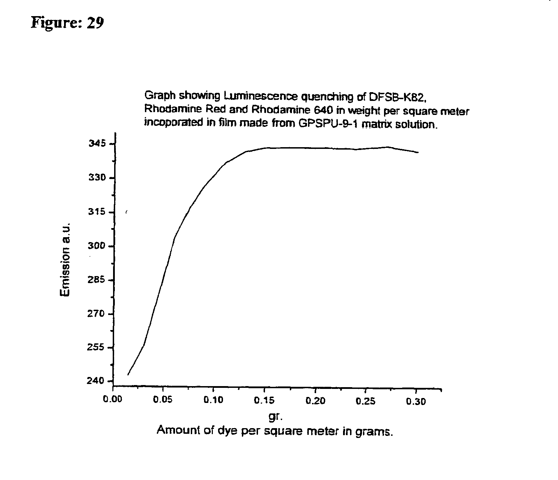

Figure 29 is a graphical representation showing luminescence quenching of a mixture of Rhodamine Red, Rhodamine 640 and DFSB-K82 in wt/m$^2$ incorporated in a film made from the GPSPU-9-1 matrix solution described herein.

## DETAILED DESCRIPTION OF THE DRAWINGS

Figure 1 gives the spectral composition of solar light at AM 1 as a function of the wave-number in cm$^{-1}$ (whereas $v$ is the frequency in s$^{-1}$ or hertz, $c$ = 3 • 10$^{10}$ times $v$). An equivalent representation of the solar spectrum as a function of the wave-length **1** in nm (1 nanometer = 10 **A**) is seen in many books and looks quite different, because the visible and near ultra-violet region is quite narrow, and abruptly cut off (by the ozone absorption in the outer atmosphere) at 300 nm, whereas the infra-red region above 800 nm is stretched out indefinitely, at least to well above 3000 nm. We prefer the representation on a wave-number scale, first of all because it gives the photon energy, secondly because the region below 10000 cm$^{-1}$ (**A** above 1000 nm) is relatively uninteresting for photovoltaic, and thirdly because the calculated current is closer related to this representation, though it might be preferred to give the photon number for this purpose, corresponding to the energy density divided by $hv$. The dashed curve on Fig. 1 is the standard spectrum of an opaque[11] object traditionally called a "black body" at the absolute temperature T = 5750 K. This corresponds quite closely to the solar spectrum outside the terrestrial atmosphere in the wave-number range considered on Fig. 1. It was discussed[23] that the maximum of such a standard spectrum as a function of the wave-length occurs at 4.9651 $kT$ where the Boltzmann constant κ = 0.695 cm-$^1$. The constant 4.9651 is the root of the transcendent equation for C = 5 in,

$$C(-^x - 1) + x = 0 \qquad\qquad (16)$$

The performance of such a concentrator (abbreviated LSC) is based on the principle of solar light entering a homogeneous medium containing a fluorescent species absorbing it. The light subsequently emitted is trapped by total reflections and concentrated by the geometrical shape.

Fig. 2. Flat-plate luminescent solar concentrator with photovoltaic ribbon on the edge. Qualitative typical emission and absorption spectra are also given. Figure 2 shows photons with an energy below the Stokes threshold hvj going directly through the upper plate. To the left of the Figure, it is suggested to heat water in a black container like the usual thermal technology. To the right, the transmitted photons hit the second plate containing another fluorescent species with a lower Stokes threshold $hv_2$. If their energy is above this second threshold, they perform essentially the same activity as in the upper plate. This approach can be generalized to a stack of three or more plates. There are two reasons for accepting this, apparently unnecessary, complication. The luminescence yield may be higher in the upper plate, compared with the unfiltered solar radiation hitting the second plate; and the ribbon of photovoltaic cell may consist of a semiconductor with higher photovoltaic threshold (energy gap) utilizing the higher photon energy of the luminescence in the first plate better. The use of the two sides of the same ribbon for two adjacent plates is discussed below. In the designs of qualitative absorption and fluorescence spectra of the two plates given in the lower part of Fig. 2, the photovoltaic threshold is assumed to be the same for the two ribbons.

Anyhow, the LSC activity within each of the two or more plates is based on the same phenomenon of total reflection outside the critical cone. Once a light ray is totally reflected, it continues an indefinite number of total reflections on the three conditions of two planar parallel surfaces of the plate, and absence of (even very weak) absorption and of scattering due to turbidity, air bubbles, and so on. On the other hand, nearly all the luminescence irradiated inside the critical cone is lost through the surfaces of the plate. The narrow air gap between the upper and the second plate seen on Fig. 2 is a necessary isolation preventing trapped luminescence in the upper plate from penetrating into the lower plate and getting absorbed.

It will be evident to those skilled in the art that the invention is not limited to the details of the foregoing illustrative embodiments and examples and that the present invention may be embodied in other specific forms without departing from essential attributes thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein.

References:

1. Weber, W. H., Lambe, J.: Appl. Optics 15, 2299 (1976);

2. Goetzberger, A., Greubel, Q.: Appl. Phys. 14, 123 (1977);

3. Swartz, B. A., Cole, T., Zewail, A. H.: Optics Letters /, 73 (1977);

4. Batchelder, J. S., Zewail, A. H., Cole, T.: Appl. Optics 18, 3090 (1979);

5. Batchelder, J. S., Zewail, A. H., Cole, T.: Soc. Photo-Opt. Instram. Eng. 248, 105 (1980);

6. Goetzberger, A., Wittwer, V.: Adv. Solid State Phys. 19, 427 (1979);

7. Reisfeld, R., Neuman, S.: Nature 274, 144 (1978);

8. Reisfeld, R., Kalisky, Y.: Nature 283, 281 (1980);

9. US Patent No. 4,661,649, Reisfeld et al."Solar Concentrator Plate, 1987;

10. US Patent No. 4,367,367, Reisfeld et al. "Collector for Solar Energy, 1983;

11. R. Reisfeld and Christian .K. Jorgensen (Eds.), "Luminescent Solar Concentrators for Energy Conversion" in "Structure and Bonding", vol. 49, (1982), p.1-3;.

12. Friedman, P. S.: Soc. Photo-Opt. Instrum. Eng. *248*, 1 (1980);

13. US Patent No. 6,476,312 B1, Keith WJ Barnham."Radiation Concentrator for a photovoltaic device, 2002;

14. US Patent No 4, 816,238, Burns et al. "Durable fluorescence Solar Concentrator", 1998;

15. A.J. Nozik,Quantum dot solar cells, Physica E 14 (2002) 115 - 120;

16. A.J. Chatten, K.W.J. Barnhama, B.F. Buxtonb, N.J. Ekins-Daukesa, M.A. Malikc, A new approach to modeling quantum dot concentrators, Solar Energy Materials & Solar Cells 75 (2003) 363-371;

17. K. L. Chopral, P. D. Paulson2*,y and V. Dutta1, Thin-Film Solar Cells: An Overview, PROGRESS IN PHOTOVOLTAICS: RESEARCH AND APPLICATIONS, Prog. Photovolt: Res. Appl. 2004; 12:69-92 (DOI: 10.1002/pip.541).

18. M.Hammam, M.K.EL-Mansy, S.M.El-Bashir, M.G.El-Shaarawy, Performance evaluation of thin-film solar concentrators for greenhouse applications, Desalination, 209,(2007)244-250.

19. Michael J. et al. Currie, High-Efficiency Organic Solar Concentrators for Photovoltaics, 226 (2008); 321 Science

**Claims**

1.  A method of producing a luminescent solar concentrator, comprising at least one plate having two major surfaces and a plurality of edges having solar cells attached thereto, said plate comprising a substrate selected from the group consisting of glass and plastic and being provided with a composite inorganic-organic sol-gel based matrix film deposited on at least one major surface thereof, wherein said film is doped with at least one luminescent dye and with silver spheroid nanoparticles of a size in the range of 8 to 60 nm, for increasing the luminescence intensity provided by said dye, and wherein said concentrator comprises at least three luminescent dyes of substantially different absorption ranges and wherein said film has a thickness of at least 10 $\mu$m, **characterized in that** the method comprises the step of producing said silver spheroid nanoparticles by the reduction of silver nanoparticles *in situ* in a hybrid composite ormosil sol-gel solution forming a matrix using silver nitrate and dimethylformamide.

2.  The method of producing a luminescent solar concentrator according to claim 1, wherein said matrix is formed including a di-urethane terminated silica network which acts as a stabilizing and coupling agent.

3.  The method of producing a luminescent solar concentrator according to claim 1 or 2, wherein the silver spheroid nanoparticles have a size in the range of 10 to 40 nm.

4.  The method of producing a luminescent solar concentrator according to one of the preceding claims, wherein a composite inorganic-organic sol-gel based, fluorescent dye doped film is deposited on both major surfaces of said plate.

5.  The method of producing a luminescent solar concentrator according to one of the preceding claims, wherein said composite inorganic-organic sol-gel based film is doped with at least two fluorescent dyes.

6.  The method of producing a luminescent solar concentrator according to one of the preceding claims, wherein a diffused reflector is positioned adjacent an underside of the luminescent solar concentrator.

7.  The method of producing a luminescent solar concentrator according to claim 6, wherein the diffused reflector is a substantially white reflector.

8.  The method of producing a luminescent solar concentrator according to one of the preceding claims, wherein said at least one luminescent dye absorbs in the solar spectrum and emits at longer wavelengths decreasing the self absorption.

9.  The method of producing a luminescent solar concentrator according to one of the preceding claims, wherein said sol-gel film has a refractive index substantially identical with that of said substrate.

10.  The method of producing a luminescent solar concentrator according to one of the preceding claims, wherein a porous anti-reflecting coating is deposited as an upper layer on the luminescent solar concentrator for diminishing the reflectance of solar light.

11.  The method of producing a luminescent solar concentrator according to one of the preceding claims, wherein said sol-gel film has a thickness of at least 20 $\mu$m.

12.  The method of producing a luminescent solar concentrator according to one of the preceding claims, wherein said sol-gel film has a thickness of at least 30 $\mu$m.

13.  The method of producing a luminescent solar concentrator according to one of the preceding claims, wherein the luminescent solar concentrator is provided with a plurality of luminescent dyes which absorb the energy of the solar spectrum in the range of between 350 and 600 nm.

14.  The method of producing a luminescent solar concentrator according to one of the preceding claims, wherein said at least one luminescent dye is monomolecularly dispersed in a glymophenylsilica-polyurethane matrix film.

15.  The method of producing a luminescent solar concentrator according to one of the preceding claims, wherein the amount of dye present in a matrix film is between 0.1 and 0.2 g/m$^2$.

**16.** The method of producing a luminescent solar concentrator according to one of the preceding claims, wherein the amount of dye present in a matrix film is between 0.13 and 0.17 g/m$^2$.

**Patentansprüche**

**1.** Verfahren zum Herstellen eines lumineszierenden konzentrierenden Sonnenkollektors (Strahlungsbündler), umfassend mindestens eine Platte mit zwei Hauptoberflächen und einer Vielzahl von Kanten mit daran befestigten Solarzellen, wobei die Platte ein Substrat umfasst, das aus der Gruppe ausgewählt wird, die aus Glass und Kunststoff besteht, und mit einem zusammengesetzten anorganischen-organischen Sol-Gelbasierten Matrixfilm versehen wird, der mindestens auf einer Hauptoberfläche davon aufgetragen wird, wobei der Film mit mindestens einem lumineszierenden Farbstoff und mit Silber-Sphäroid-Nanopartikeln mit einer Größe im Bereich von 8 bis 60 nm dotiert wird, um die durch den Farbstoff bereitgestellte Lumineszenzintensität zu erhöhen, und wobei der konzentrierende Kollektor mindestens drei lumineszierende Farbstoffe mit im wesentlichen unterschiedlichen Absorptionsbereichen umfasst und wobei der Film eine Dicke von mindestens 10 μm aufweist,
**dadurch gekennzeichnet, dass**
das Verfahren den Schritt umfasst, dass die Silber-Sphäroid-Nanopartikel durch die Reduktion von Silbernanopartikeln *in situ* in einer hybriden zusammengesetzten Ormosil-Sol-Gel-Lösung, die eine Matrix bildet, hergestellt werden, wobei Silbernitrat und Dimethylformamid verwendet werden.

**2.** Verfahren zum Herstellen eines lumineszierenden konzentrierenden Sonnenkollektors nach Anspruch 1, wobei die Matrix einschließlich eines Diurethan-terminierten Silica-Netzwerks, das als ein stabilisierendes Mittel und als Kopplungsmittel wirkt, gebildet wird.

**3.** Verfahren zum Herstellen eines lumineszierenden konzentrierenden Sonnenkollektors nach Anspruch 1 oder 2, wobei die Silber-Sphäroid-Nanopartikel eine Größe im Bereich von 10 bis 40 nm aufweisen.

**4.** Verfahren zum Herstellen eines lumineszierenden konzentrierenden Sonnenkollektors nach einem der vorherigen Ansprüche, wobei ein zusammengesetzter anorganisch-organisch Sol-Gel-basierter, mit einem fluoreszierenden Farbstoff dotierter Film auf beiden Hauptoberflächen der Platte aufgebracht wird.

**5.** Verfahren zum Herstellen eines lumineszierenden konzentrierenden Sonnenkollektors nach einem der vorherigen Ansprüche, wobei der Film auf Basis eines zusammengesetzten anorganischen-organischen Sol-Gels mit mindestens zwei fluoreszierenden Farbstoffen dotiert wird.

**6.** Verfahren zum Herstellen eines lumineszierenden konzentrierenden Sonnenkollektors nach einem der vorherigen Ansprüche, wobei ein streuender Reflektor benachbart zu einer Unterseite des lumineszierenden konzentrierenden Sonnenkollektors angebracht wird.

**7.** Verfahren zum Herstellen eines lumineszierenden konzentrierenden Sonnenkollektors nach Anspruch 6, wobei der streuende Reflektor ein im Wesentlichen weißer Reflektor ist.

**8.** Verfahren zum Herstellen eines lumineszierenden konzentrierenden Sonnenkollektors nach einem der vorherigen Ansprüche, wobei der mindestens eine lumeniszierende Farbstoff in dem Sonnenspektrum absorbiert und bei einer längeren Wellenlänge abstrahlt, wodurch die Selbstabsorption verringert wird.

**9.** Verfahren zum Herstellen eines lumineszierenden konzentrierenden Sonnenkollektors nach einem der vorherigen Ansprüche, wobei der Sol-Gel-Film einen Refraktionsindex aufweist, der im Wesentlichen identisch zu dem des Substrats ist.

**10.** Verfahren zum Herstellen eines lumineszierenden konzentrierenden Sonnenkollektors nach einem der vorherigen Ansprüche, wobei eine poröse Anti-Reflex-Beschichtung als eine obere Schicht auf dem lumineszierenden konzentrierenden Sonnenkollektor aufgebracht wird, um die Reflektion von Sonnenlicht zu verringern.

**11.** Verfahren zum Herstellen eines lumineszierenden konzentrierenden Sonnenkollektors nach einem der vorherigen Ansprüche, wobei der Sol-Gel-Film eine Dicke von mindestens 20 μm aufweist.

**12.** Verfahren zum Herstellen eines lumineszierenden konzentrierenden Sonnenkollektors nach einem der vorherigen Ansprüche, wobei der Sol-Gel-Film eine Dicke von mindestens 30 μm aufweist.

13. Verfahren zum Herstellen eines lumineszierenden konzentrierenden Sonnenkollektors nach einem der vorherigen Ansprüche, wobei der lumineszierende konzentrierende Solarkollektor mit einer Vielzahl von lumineszierenden Farbstoffen versehen wird, die die Energie des Sonnenspektrums in dem Bereich von zwischen 350 und 600 nm absorbieren.

14. Verfahren zum Herstellen eines lumineszierenden konzentrierenden Sonnenkollektors nach einem der vorherigen Ansprüche, wobei der mindestens eine lumineszierende Farbstoff monomolekular in einem Glymophenylsilica-Polyurethan-Matrixfilm dispergiert wird.

15. Verfahren zum Herstellen eines lumineszierenden konzentrierenden Sonnenkollektors nach einem der vorherigen Ansprüche, wobei die Menge an Farbstoff, der in einem Matrixfilm vorhanden ist, zwischen 0,1 und 0,2 g/m$^2$ beträgt.

16. Verfahren zum Herstellen eines lumineszierenden konzentrierenden Sonnenkollektors nach einem der vorherigen Ansprüche, wobei die Menge an Farbstoff, der in einem Matrixfilm vorhanden ist, zwischen 0,13 und 0,17 g/m$^2$ beträgt.

## Revendications

1. Procédé de fabrication d'un concentrateur solaire luminescent, comprenant au moins une plaque ayant deux grandes surfaces et une pluralité de bords sur lesquels sont fixées des cellules solaires, ladite plaque comprenant un substrat choisi dans le groupe constitué de verre et de plastique et étant pourvue d'un film matriciel composite à base de sol-gel inorganique-organique déposé sur au moins une grande surface de celle-ci, dans lequel ledit film est dopé avec au moins un colorant luminescent et avec des nanoparticules sphéroïdales d'argent d'une taille se trouvant dans la plage allant de 8 à 60 nm, pour augmenter l'intensité de luminescence fournie par ledit colorant, et dans lequel ledit concentrateur comprend au moins trois colorants luminescents de plages d'absorption sensiblement différentes et dans lequel ledit film a une épaisseur d'au moins 10 μm, **caractérisé en ce que** le procédé comprend l'étape qui consiste à fabriquer lesdites nanoparticules sphéroïdales d'argent par la réduction de nanoparticules d'argent *in situ* dans une solution hybride composite sol-gel à base d'ormosils formant une matrice en utilisant du nitrate d'argent et du diméthylformamide.

2. Procédé de fabrication d'un concentrateur solaire luminescent selon la revendication 1, dans lequel ladite matrice est formée de manière à inclure un réseau de silice à terminaison diuréthane qui agit en tant qu'agent de stabilisation et de couplage.

3. Procédé de fabrication d'un concentrateur solaire luminescent selon la revendication 1 ou 2, dans lequel les nanoparticules sphéroïdales d'argent ont une taille se trouvant dans la plage allant de 10 à 40 nm.

4. Procédé de fabrication d'un concentrateur solaire luminescent selon l'une des revendications précédentes, dans lequel un film composite dopé avec un colorant fluorescent, à base de sol-gel inorganique-organique est déposé sur les deux grandes surfaces de ladite plaque.

5. Procédé de fabrication d'un concentrateur solaire luminescent selon l'une des revendications précédentes, dans lequel ledit film composite à base de sol-gel inorganique-organique est dopé avec au moins deux colorants fluorescents.

6. Procédé de fabrication d'un concentrateur solaire luminescent selon l'une des revendications précédentes, dans lequel un réflecteur diffus est positionné de manière adjacente à une face inférieure du concentrateur solaire luminescent.

7. Procédé de fabrication d'un concentrateur solaire luminescent selon la revendication 6, dans lequel le réflecteur diffus est un réflecteur sensiblement blanc.

8. Procédé de fabrication d'un concentrateur solaire luminescent selon l'une des revendications précédentes, dans lequel ledit au moins un colorant luminescent absorbe dans le spectre solaire et émet à des longueurs d'onde plus grandes réduisant ainsi l'auto-absorption.

9. Procédé de fabrication d'un concentrateur solaire luminescent selon l'une des revendications précédentes, dans lequel ledit film de sol-gel a un indice de réfraction sensiblement identique à celui dudit substrat.

10. Procédé de fabrication d'un concentrateur solaire luminescent selon l'une des revendications précédentes, dans lequel un revêtement poreux anti-réfléchissant est déposé en tant que couche supérieure sur le concentrateur solaire luminescent pour diminuer la réflectance de la lumière solaire.

11. Procédé de fabrication d'un concentrateur solaire luminescent selon l'une des revendications précédentes, dans lequel ledit film de sol-gel a une épaisseur d'au moins 20 $\mu$m.

12. Procédé de fabrication d'un concentrateur solaire luminescent selon l'une des revendications précédentes, dans lequel ledit film sol-gel a une épaisseur d'au moins 30 $\mu$m.

13. Procédé de fabrication d'un concentrateur solaire luminescent selon l'une des revendications précédentes, dans lequel le concentrateur solaire luminescent est pourvu d'une pluralité de colorants luminescents qui absorbent l'énergie du spectre solaire dans la plage comprise entre 350 et 600 nm.

14. Procédé de fabrication d'un concentrateur solaire luminescent selon l'une des revendications précédentes, dans lequel ledit au moins un colorant luminescent est dispersé de manière monomoléculaire dans un film matriciel de glymophénylsilice-polyuréthane.

15. Procédé de fabrication d'un concentrateur solaire luminescent selon l'une des revendications précédentes, dans lequel la quantité de colorant présent dans un film matriciel est comprise entre 0,1 et 0,2 g/m$^2$.

16. Procédé de fabrication d'un concentrateur solaire luminescent selon l'une des revendications précédentes, dans lequel la quantité de colorant présent dans un film matriciel est comprise entre 0,13 et 0,17 g/m$^2$.

**Figure 1.**

The solar spectrum at standard conditions (AMI) as a function of the wave-number (full line).

## Figure2.

### Fig. 2a. Flat-plate luminescent solar concentrator with photovoltaic ribbon on the edge.

Critical angle for
total reflection
$h\nu_2 < h\nu < h\nu_1$

Lost

$h\nu < h\nu_1$

p-n junction
photovoltaic
ribbon

Hot water

Second plate

### Fig 2b: Emission and Absorption spectra of LSC of Fig. 2a

Luminescence

Upper
plate

Absorption

$h\nu$

Stokes threshold
$h\nu_1$

Second
plate

Absorption

$h\nu$

Photovoltaic
threshold

Stokes threshold
$h\nu_2$

**Figure 3**

DFSB-K-61-Clear Blue Dye
Absorption spectrum

**Figure 4**

DFSB-K-61-Clear Blue Dye
Excitation and Emission spectra

**Figure 5**

DFSB-K82- Yellow Dye.
Absorption spectrum

**Figure 6**

DFSB-K82- Yellow Dye.
Excitation and Emission spectra

**Figure 7**
Rhodamine red Dye;
Absorption spectrum

**Figure 8**
Rhodamine red Dye;
Excitation and Emission spectra

**Figure 9**
Rhodamine 640 Dye
. Absorption spectrum

**Figure 10**
Rhodamine 640 Dye
Excitation and Emission spectra

**Figure 11**
Combination of two dyes
Abs. of Rhodamine Red and Rd.640

**Figure 12**
Combination of two dyes
Exc. and Em. of Rd.Red and Rd 640

**Figures 13**
Combination of three dyes
Abs. of Rd. Red , Rd.640 and Yellow,

**Figures 14**
Combination of three dyes
Exc. & Em. of Rd. Red, Rd.640 & Yellow

EP 2 327 108 B1

**Figure 15**
Antireflective coating-modified (ARCM)

ARCM-1.0-90min-17minTritm

**Figure 16**
Antireflective coating-modified (ARCM)

ARCM-0.5-32min-14minTritm.

**Figure 17**
Silver Nanoparticles (Ag NPs)
Absorption spectrum of Silver NPs.

26

Figure 18
Silver Nanoparticles (Ag NPs)
SEM image of synthesized silver NPs

**Figure 19**
Absorption spectra of Rd B-dye in
GPSPU-ZR-1 matrix with and without
Ag NPs

**Figure 20**
Intensification of luminescence with
presence of Ag NPs.

**Figure: 21**

**Figure: 22**

**Figure: 23**

Figure: 24

Figure: 25

**Figure: 26**

**Figure: 27**

Figure: 28

**Figure: 29**

Graph showing Luminescence quenching of DFSB-K82, Rhodamine Red and Rhodamine 640 in weight per square meter incoporated in film made from GPSPU-9-1 matrix solution.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0054340 A1
- US 2008149165 A1
- US 4661649 A, Reisfeld
- US 4367367 A, Reisfeld
- US 6476312 B1, Keith WJ Barnham
- US 4816238 A, Burns

### Non-patent literature cited in the description

- **WEBER, W. H. ; LAMBE, J.** *Appl. Optics,* 1976, vol. 15, 2299
- **GOETZBERGER, A. ; GREUBEL, Q.** *Appl. Phys.,* 1977, vol. 14, 123
- **SWARTZ, B. A. ; COLE, T. ; ZEWAIL, A. H.** *Optics Letters,* 1977, vol. 73
- **BATCHELDER, J. S. ; ZEWAIL, A. H. ; COLE, T.** *Appl. Optics,* 1979, vol. 18, 3090
- **BATCHELDER, J. S. ; ZEWAIL, A. H. ; COLE, T.** *Soc. Photo-Opt. Instram. Eng.,* 1980, vol. 248, 105
- **GOETZBERGER, A. ; WITTWER, V.** *Adv. Solid State Phys.,* 1979, vol. 19, 427
- **REISFELD, R. ; NEUMAN, S.** *Nature,* 1978, vol. 274, 144
- **REISFELD, R. ; KALISKY, Y.** *Nature,* 1980, vol. 283, 281
- Luminescent Solar Concentrators for Energy Conversion. Structure and Bonding. 1982, vol. 49, 1-3
- **A.J. NOZIK.** Quantum dot solar cells. *Physica E,* 2002, vol. 14, 115-120
- **A.J. CHATTEN ; K.W.J. BARNHAMA ; B.F. BUXTONB ; N.J. EKINS-DAUKESA ; M.A. MA-LIKC.** A new approach to modeling quantum dot concentrators. *Solar Energy Materials & Solar Cells,* 2003, vol. 75, 363-371
- **K. L. CHOPRAL ; P. D. PAULSON2*,Y ; V. DUTTA1.** Thin-Film Solar Cells: An Overview, PROGRESS IN PHOTOVOLTAICS: RESEARCH AND APPLICATIONS. *Prog. Photovolt: Res. Appl.,* 2004, vol. 12, 69-92
- **M.HAMMAM ; M.K.EL-MANSY ; S.M.EI-BASHIR ; M.G.EL-SHAARAWY.** Performance evaluation of thin-film solar concentrators for greenhouse applications. *Desalination,* 2007, vol. 209, 244-250
- **MICHAEL J. et al.** Currie, High-Efficiency Organic Solar Concentrators for Photovoltaics. *Science,* 2008, vol. 226, 321